Europäisches Patentamt

European Patent Office

Office européen des brevets

(11) Publication number : **0 451 782 B1**

(12) **EUROPEAN PATENT SPECIFICATION**

(45) Date of publication of patent specification :
27.12.95 Bulletin 95/52

(51) Int. Cl.⁶ : **H01L 39/24**

(21) Application number : **91105601.8**

(22) Date of filing : **09.04.91**

(54) **Method of preparing oxide superconducting film**

(30) Priority : **11.04.90 JP 95465/90**
**11.03.91 JP 45059/90**

(43) Date of publication of application :
**16.10.91 Bulletin 91/42**

(45) Publication of the grant of the patent :
**27.12.95 Bulletin 95/52**

(84) Designated Contracting States :
**DE FR GB**

(56) References cited :
**EP-A- 0 341 520**
**APPLIED PHYSICS LETTERS vol. 56, no. 15, 9**
**April 1990, NEW YORK, pages 1481-1483; Wu**
**X.D. et al: 'Effects of deposition rate on**
**properties of YBa2Cu307 - superconducting**
**thin films'**
**APPLIED PHYSICS LETTERS vol. 54, no. 22, 29**
**May 1989, NEW YORK, US pages 2271-2273;**
**Singh, R.K. et al: 'In situ processing of epitaxi-**
**al Y-Ba-Cu-0 high Tc superconducting films on**
**(100) SrTiO3 and (100) YS-Zr02 substrates at**
**500-650 degrees C'**
**APPLIED PHYSICS LETTERS vol. 55, no. 23, 4**
**December 1989, New York, US pages**
**2450-2452; Koren G. et al: 'Laser wavelength**
**dependent properties of YBa2Cu307-d thin**
**films deposited by laser ablation'**
**ICMC '90 Topical Conference, High-Tempreat-**
**ure Superconductors, Material Aspects, May**
**9-11 1990, Garmisch-Partenkirchen,**
**"Preparation and Properties of Y-Ba-Cu-O**
**Thin Films Prepared by Excimer Laser**
**Ablation", S. Okuda et al.**
**Applied Physics Letters, Vol. 57, No. 16, 15th**
**October 1990, pp. 1687-1689, B. H. Moeckly et**
**al.**
**AIP Conf. Proc., Vol. 165., 1988, pp. 132-140, D.**
**S. Yee et al.**
**Applied Physics Letters, vol. 57, No. 5, 30th**
**July 1990, pp. 523-525, X. D. Wu et al.**

(73) Proprietor : **SUMITOMO ELECTRIC**
**INDUSTRIES, LTD.**
**5-33, Kitahama 4-chome,**
**Chuo-ku**
**Osaka-shi, Osaka 541 (JP)**
(84) **DE FR GB**
Proprietor : **The Tokyo Electric Power Co., Inc.**
**1-3, Uchisaiwai-cho, 1-chome**
**Chiyoda-ku Tokyo (JP)**
(84) **DE**

(72) Inventor : **Yoshida, Noriyuki, c/o Osaka Works**
**of**
**Sumitomo Electric Industries, Ltd.**
**1-3, Shimaya 1-chome, Konohana-ku, Osaka**
**(JP)**
Inventor : **Takano, Satoshi, c/o Osaka Works of**
**Sumitomo Electric Industries, Ltd.**
**1-3, Shimaya 1-chome, Konohana-ku, Osaka**
**(JP)**
Inventor : **Okuda, Shigeru, c/o Osaka Works of**
**Sumitomo Electric Industries, Ltd.**
**1-3, Shimaya 1-chome, Konohana-ku, Osaka**
**(JP)**
Inventor : **Hayashi, Noriki, c/o Osaka Works of**
**Sumitomo Electric Industries, Ltd.**
**1-3, Shimaya 1-chome, Konohana-ku, Osaka**
**(JP)**
Inventor : **Hara, Tsukushi, The Tokyo Electric**
**Power Co Inc**
**4-1 Nishi-tsutsujigaoka 2-chome**
**Chofu-shi, Tokyo (JP)**
Inventor : **Okaniwa, Kiyoshi, The Tokyo**
**Electric Power Co Inc**
**4-1 Nishi-tsutsujigaoka 2-chome**
**Chofu-shi, Tokyo (JP)**
Inventor : **Yamamoto, Takahiko, The Tokyo**
**Electric Power Co In**
**4-1 Nishi-tsutsujigaoka 2-chome**
**Chofu-shi, Tokyo (JP)**

(74) Representative : **KUHNEN, WACKER &**
**PARTNER**
**Alois-Steinecker-Strasse 22**
**D-85354 Freising (DE)**

## Description

## BACKGROUND OF THE INVENTION

Field of the Invention

The present invention relates to a method of preparing an oxide superconducting film using laser ablation.

Description of the Background Art

A method of forming an oxide superconducting film by laser ablation with an excimer laser beam, for example, is watched with interest in the point that it is possible to easily implement a high-quality film. In general, a pulse laser beam is employed for laser ablation.

In such laser ablation, the film has generally been formed at a relatively low film deposition rate with a pulsed laser repetition rate of not more than 10 Hz. According to published literature such as Appl. Phys. Lett., Vol. 53, No. 16, pp. 1557 - 1559 (1988), "Epitaxial growth of $YBa_2Cu_3O_{7-x}$ thin films by a laser evaporation process", for example, the known maximum film deposition rate is 1200 Å/min. In p. 1557, the above literature describes film deposition conditions of 4 Å/pulse and 1500 laser pulses for 5 minutes, which result in the aforementioned film deposition rate of 1200 Å/min.

The maximum film deposition rate has been thus limited to 1200 Å/min., for example, in general laser ablation conceivably for the reasons that this film deposition rate is sufficiently higher than those in other film deposition techniques such as sputtering, vacuum deposition etc. and no higher rate is required in application to the field of electronics, and that superconducting properties of the as-deposited oxide superconducting film are reduced at a higher film deposition rate.

When an oxide superconducting film is formed by ordinary laser ablation, the film deposition rate is increased by increase of the repetition rate. However, if the film deposition rate is increased in excess of 2000 Å/min., for example, the oxide superconducting film is obtained as an aggregate of fine crystal grains of not more than 1 μm, to develop clear grain boundaries. This leads to reduction in critical temperature and critical current density.

Up to now, therefore, it has been impossible to implement a high-quality oxide superconducting film having excellent superconducting properties at a high film deposition rate.

Wu X. D. et al (Appl. Physics Letter vol. 56 no. 15 (1990) 1481-3) discloses laser ablation of oxide superconducting films with a deposition rate of up to 8700 Å/min, but does not disclose values for the critical current density. AIP Conf. Proc. Vol. 165, pp. 132-140 (1988) discloses readiness of grain boundary generation between $SrTiO_3$ and MgO.

## SUMMARY OF THE INVENTION

Accordingly, an object of the present invention is to provide a method of preparing an oxide superconducting film, whose superconducting properties are not much reduced even if the same is formed at a higher rate than those in conventional methods.

The present invention is directed to a method of preparing a high temperature oxide superconducting film having a critical current density of at least $1 \times 10^5$ A/cm$^2$ on a substrate using laser ablation, comprising the steps of applying a laser beam to a target containing components of an oxide superconductor material and depositing particles, being scattered from said target, on the substrate, wherein said conditions of said film deposition satisfy the following conditions

a. an oxygen gas flow rate during film deposition of 50 to 70 SCCM;

b. am oxygen gas pressure during film deposition of 0.13332 to 133.32 Pa (10 to 1000 mTorr);

c. a target-to-substrate distance of 40 to 60 mm;

d. a substate temperature of 600 to 800 °C;

e. a laser energy density on the target surface of 1 to 3 J/cm2; and

f. laser pulse energy of at least 10 mJ.

In relation to such a method of preparing an oxide superconducting film using laser ablation, the inventors have found that it is possible to obtain an oxide superconducting film having excellent superconducting properties at a high film deposition rate by selecting film deposition conditions, i.e., the oxygen gas flow rate and the oxygen gas pressure during film deposition, the target-to-substrate distance, the substrate temperature, the energy density of the laser beam on the target surface and the laser pulse energy in more specific terms, in prescribed ranges respectively.

The inventive method of preparing an oxide superconducting film has the following features: The film deposition rate is not lower than 12300 Å/min, and a MgO substrate is used.

The present invention is advantageously applicable to preparation of a yttrium-system oxide superconducting film having a composition of Y-Ba-Cu-O, for example.

According to the present invention, it is possible to obtain a high-quality oxide superconducting film having excellent superconducting properties at a film deposition rate of at least 12300 Å/min., as clearly understood from Examples described later. In other words, superconducting properties of the as-deposited oxide superconducting film are not substantially reduced even if the film deposition rate is in excess of 12300 Å/min. Therefore, it can be said that the present invention has a particularly remarkable effect at a film deposition rate exceeding 12300 Å/min.

Thus, the present invention can effectively improve the quality of an oxide superconducting film at a high film deposition rate, and hence the same is particularly effectively applied to preparation of an oxide superconducting wire which is obtained by employing a long tape-type base material, for example, as a substrate, and continuously forming an oxide superconducting film thereon.

BRIEF DESCRIPTION OF THE DRAWING

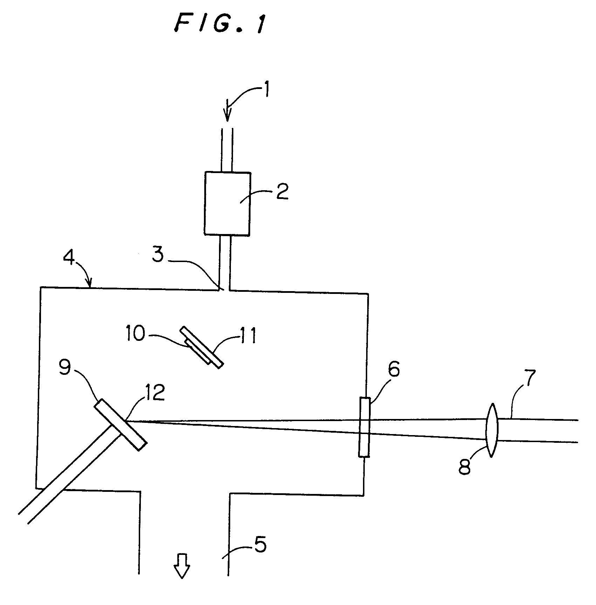

Fig. 1 is a sectional view illustrating a film deposition apparatus which is adapted to carry out an embodiment of the present invention.

DESCRIPTION OF THE PREFERRED EMBODIMENTS

1 Torr = 133.32 Pa = 1.3332 mbar

Fig. 1 shows a state of carrying out an embodiment of the present invention.

Gaseous oxygen, which is supplied along an arrow 1, is flow-controlled by a flow controller 2, and then introduced into a film deposition chamber 4 from an inlet 3. An evacuation port 5 is provided in another position of the film deposition chamber 4, and the displacement of a vacuum pump (not shown), which is connected to the evacuation port 5, is adjusted by a control valve or the like, so that the oxygen gas pressure in the film deposition chamber 4 can be maintained at a prescribed value.

A window 6 of synthetic quartz glass, for example, is provided on a wall portion of the film deposition chamber 4. A laser beam 7 is focused by a condenser lens 8, and introduced into the film deposition chamber 4 through the window 6.

In the film deposition chamber 4, the laser beam 7 is applied to the surface of a target 9, which is prepared from a sintered body of an oxide superconductive material such as $Y_1Ba_2Cu_3O_x$, for example. A substrate 10 is held on a substrate holder 11, which contains a heater for heating the substrate 10. The substrate 10 is arranged to be parallel to the target 9 along a normal through a position 12, which is irradiated with the laser beam 7, of the target 9.

The point of the present invention resides in that film deposition conditions which can attain a high-quality oxide superconducting film at a high film deposition rate exceeding 12300Å/min., for example, have been found. Six film deposition conditions a to f are defined in claims. When these film deposition conditions are satisfied, a high-quality oxide superconducting film can be obtained even if the film is formed at a high rate. However, it is impossible to obtain an oxide superconducting film having excellent superconducting properties if at least one of these conditions is not satisfied.

Experimental Examples carried out for deciding the film deposition conditions are now described. These Experimental Examples prove that it is impossible to obtain an oxide superconducting film having excellent superconducting properties at a high film deposition rate exceeding 12300 Å/min., for example, if any one of the film deposition conditions is not satisfied. Six Experimental Examples have been carried out in correspondence to the aforementioned six film deposition conditions.

The film deposition apparatus shown in Fig. 1 was employed for every Experimental Example with a substrate 10 of single-crystalline MgO (100), a KrF excimer laser beam 7 of 248 nm in wavenlength, and a target 9 of a $Y_1Ba_2Cu_3O_x$ sintered body, to form a $Y_1Ba_2Cu_3O_x$ oxide superconducting film on a substrate 10. In order to investigate changes of the superconducting properties caused by increase of the film deposition rate in every Experimental Example, the laser repetition rate [Hz] was varied in a range of 1, 5, 10, 20, 30, 50, 100, 200 and 250 for changing the film deposition rate, to evaluate the superconducting properties of samples obtained under the respective repetition rates.

3

Experimental Example 1 (Oxygen Gas Flow Rate)

Except for the laser repetition rate and the oxygen gas flow rate during film deposition as described above, the film deposition conditions were set as follows:

Oxygen Gas Pressure during Film Deposition: 200 mTorr

Target-to-Substrate Distance: 70 mm

Substrate Temperature: 675°C

Energy Density of laser Beam on Target Surface: 2.5 J/cm$^2$

Laser Pulse Energy: 350 mJ

The oxygen gas flow rate [SCCM] during film deposition was varied as shown in Table 1, to form films under the respective repetition rates.

EP 0 451 782 B1

Referring to Table 1, the numerals listed with no item names show critical current densities, which were

## Table 1

| Repetition Rate | | 1 | 5 | 10 | 20 | 30 | 50 | 100 | 200 | 250 |
|---|---|---|---|---|---|---|---|---|---|---|
| Oxygen Gas Flow Rate During Film Deposition | 30 | $1.2 \times 10^6$ | $2.3 \times 10^5$ | $1.2 \times 10^3$ | 0 | 0 | 0 | 0 | $8.3 \times 10^2$ | $2.6 \times 10^2$ |
| | 40 | $1.4 \times 10^6$ | $1.3 \times 10^6$ | $1.2 \times 10^6$ | $1.4 \times 10^6$ | $2.2 \times 10^5$ | $1.2 \times 10^4$ | $1.3 \times 10^3$ | $4.2 \times 10^5$ | $2.1 \times 10^4$ |
| | 50 | $1.2 \times 10^6$ | $1.4 \times 10^6$ | $1.1 \times 10^6$ | $1.5 \times 10^6$ | $1.0 \times 10^6$ | $9.5 \times 10^5$ | $9.2 \times 10^5$ | $1.6 \times 10^6$ | $1.1 \times 10^6$ |
| | 60 | $2.3 \times 10^6$ | $2.5 \times 10^6$ | $2.2 \times 10^6$ | $2.0 \times 10^6$ | $1.7 \times 10^6$ | $1.3 \times 10^6$ | $1.5 \times 10^6$ | $1.1 \times 10^6$ | $1.2 \times 10^6$ |
| | 70 | $3.1 \times 10^6$ | $3.4 \times 10^6$ | $3.2 \times 10^6$ | $2.8 \times 10^6$ | $2.3 \times 10^6$ | $1.8 \times 10^6$ | $1.4 \times 10^6$ | $9.8 \times 10^5$ | $1.2 \times 10^6$ |
| Film Deposition Rate | | 65 | 320 | 705 | 1390 | 2250 | 3670 | 7820 | 16200 | 18950 |

measured at the boiling point of 77.3 K of liquid nitrogen, in units of [A/cm$^2$]. In the samples showing critical current densities of "0", superconductivity transition temperatures were less than the boiling point of 77.3 K of liquid nitrogen and no critical current flowed at the temperature of 77.3 K. This also applies to Experimental Examples 2 to 6 described later.

Referring to Table 1, further, the film deposition rates represent average values of those obtained under various oxygen gas flow rates during film deposition, in units of [Å/min.].

It is clearly understood from Table 1 that critical current densities of at least or substantially equal to 1 x 10$^6$ A/cm$^2$ were obtained at the film deposition rates exceeding 2250 Å/min., when the oxygen gas flow rates during film deposition were in excess of 50 SCCM. When the oxygen gas flow rates during film deposition were less than 50 SCCM, on the other hand, the properties were abruptly reduced at the film deposition rates exceeding 2000 Å/min., although it was possible to attain high properties at the film deposition rates of not more than 20000 Å/min.

Experimental Example 2 (Oxygen Gas Pressure)

Except for the laser repetition rate and the oxygen gas pressure during film deposition, the film deposition conditions were set as follows:

Oxygen Gas Flow Rate during Film Deposition: 100 SCCM
Target-to-Substrate Distance: 70 mm
Substrate Temperature: 700°C
Energy Density of Laser Beam on Target Surface: 1.5 J/cm$^2$
Laser Pulse Energy: 390 mJ

The oxygen gas pressure [mTorr] during film deposition was varied as shown in Table 2, to form films under the respective repetition rates.

As to the numerical values shown in Table 2 with no item names, the upper values show critical current densities [A/cm$^2$], and the lower values show film deposition rates [Å/min.].

**Table 2**

| Repetition Rate \ Oxygen Gas Pressure During Film Deposition | 1 | 5 | 10 | 20 | 30 | 50 | 100 | 200 | 250 |
|---|---|---|---|---|---|---|---|---|---|
| 5 | $1.3 \times 10^2$ / 72 | $1.4 \times 10^3$ / 280 | 0 / 420 | 0 / 790 | 0 / 1120 | 0 / 1600 | 0 / 3200 | 0 / 6600 | 0 / 8100 |
| 10 | $4.5 \times 10^5$ / 55 | $4.2 \times 10^5$ / 290 | $4.3 \times 10^5$ / 590 | $2.8 \times 10^5$ / 1060 | $4.0 \times 10^5$ / 1520 | $3.8 \times 10^5$ / 2630 | $3.1 \times 10^5$ / 5190 | $2.7 \times 10^5$ / 11200 | $2.2 \times 10^5$ / 13800 |
| 50 | $1.8 \times 10^6$ / 63 | $1.6 \times 10^6$ / 310 | $1.4 \times 10^6$ / 620 | $1.2 \times 10^6$ / 1210 | $9.2 \times 10^5$ / 1790 | $6.3 \times 10^5$ / 3110 | $6.2 \times 10^5$ / 6150 | $5.8 \times 10^5$ / 12200 | $5.9 \times 10^5$ / 15600 |
| 100 | $2.7 \times 10^6$ / 69 | $1.9 \times 10^6$ / 320 | $1.8 \times 10^6$ / 670 | $2.5 \times 10^6$ / 1290 | $2.2 \times 10^6$ / 2010 | $2.1 \times 10^6$ / 3190 | $1.9 \times 10^6$ / 6450 | $1.3 \times 10^6$ / 12800 | $1.1 \times 10^6$ / 16200 |
| 300 | $2.5 \times 10^6$ / 72 | $2.2 \times 10^6$ / 320 | $1.9 \times 10^6$ / 700 | $1.3 \times 10^6$ / 1380 | $1.1 \times 10^6$ / 2110 | $1.5 \times 10^6$ / 3100 | $8.9 \times 10^5$ / 6320 | $1.1 \times 10^6$ / 13000 | $9.2 \times 10^5$ / 16300 |
| 500 | $2.8 \times 10^6$ / 81 | $2.3 \times 10^6$ / 330 | $3.0 \times 10^6$ / 720 | $2.5 \times 10^6$ / 1410 | $1.9 \times 10^6$ / 2200 | $1.7 \times 10^6$ / 3200 | $1.2 \times 10^6$ / 6010 | $1.1 \times 10^6$ / 12300 | $9.8 \times 10^5$ / 16100 |
| 1000 | $1.9 \times 10^6$ / 70 | $1.5 \times 10^6$ / 320 | $1.9 \times 10^6$ / 710 | $1.3 \times 10^6$ / 1390 | $1.5 \times 10^6$ / 2100 | $1.3 \times 10^6$ / 3300 | $1.1 \times 10^6$ / 6500 | $9.3 \times 10^5$ / 13100 | $8.7 \times 10^5$ / 16200 |
| 1200 | $1.3 \times 10^6$ / 60 | $1.2 \times 10^6$ / 330 | $1.5 \times 10^6$ / 630 | $9.1 \times 10^5$ / 1290 | $1.2 \times 10^4$ / 2110 | $1.1 \times 10^3$ / 3260 | 0 / 6600 | 0 / 13500 | 0 / 16300 |

It is clearly understood from Table 2 that the critical current densities were extremely reduced or zeroed when the oxygen gas pressures during film deposition were below 10 mTorr, as in the case of 5 mTorr, regardless of the film deposition rates.

When the oxygen gas pressures were 10 mTorr, the samples attained critical current densities along the order of $10^5$ A/cm$^2$, at the film deposition rates exceeding 2000 Å/min. When the oxygen gas pressures were selected in the range of 10 to 1000 mTorr, it was possible to maintain high properties at the film deposition rates exceeding 2000 Å/min.

When the oxygen gas pressures exceeded 1000 mTorr as in the case of 1200 mTorr, on the other hand, the properties were significantly reduced at the film deposition rates exceeding 2000 Å/min.

Experimental Example 3 [Target-to-Substrate Distance)

Except for the laser repetition rate and the target-to-substrate distance, the film deposition conditions were set as follows:

Oxygen Gas Flow Rate during Film Deposition: 100 SCCM
Oxygen Gas Pressure during Film Deposition: 200 mTorr
Substrate Temperature: 700°C
Laser Energy Density on Target Substrate: 1.5 J/cm$^2$
Laser Pulse Energy: 390 mJ

The target-to-substrate distance [mm] was varied as shown in Table 3, to form films under the respective repetition rates.

As to the numerical values listed with no item names in Table 3, the upper values show critical current densities [A/cm$^2$] and the lower values show film deposition rates [Å/min.], similarly to Table 2.

Table 3

| Repetition Rate | 250 | 200 | 100 | 50 | 30 | 20 | 10 | 5 | 1 |
|---|---|---|---|---|---|---|---|---|---|
| 30 | 0<br>78000 | 0<br>61000 | 0<br>29200 | 0<br>14100 | 0<br>8250 | 0<br>5210 | $1.1 \times 10^{2}$<br>2750 | $1.3 \times 10^{2}$<br>1320 | $2.6 \times 10^{3}$<br>255 |
| 40 | $8.2 \times 10^{5}$<br>41000 | $8.4 \times 10^{5}$<br>33000 | $1.0 \times 10^{6}$<br>16200 | $1.1 \times 10^{6}$<br>7800 | $9.3 \times 10^{5}$<br>4710 | $9.8 \times 10^{5}$<br>3090 | $1.3 \times 10^{6}$<br>1530 | $1.1 \times 10^{6}$<br>692 | $2.1 \times 10^{6}$<br>148 |
| 60 | $9.2 \times 10^{5}$<br>17100 | $1.0 \times 10^{6}$<br>13500 | $1.5 \times 10^{6}$<br>6670 | $1.2 \times 10^{6}$<br>3410 | $1.8 \times 10^{6}$<br>1910 | $1.5 \times 10^{6}$<br>1290 | $2.1 \times 10^{6}$<br>650 | $3.1 \times 10^{6}$<br>300 | $3.5 \times 10^{6}$<br>62 |
| 80 | $1.0 \times 10^{6}$<br>8100 | $1.4 \times 10^{6}$<br>6200 | $1.3 \times 10^{6}$<br>3050 | $1.8 \times 10^{6}$<br>1710 | $1.9 \times 10^{6}$<br>1020 | $2.7 \times 10^{6}$<br>670 | $2.1 \times 10^{6}$<br>330 | $2.5 \times 10^{6}$<br>160 | $1.8 \times 10^{6}$<br>31 |
| 100 | $1.0 \times 10^{6}$<br>5750 | $9.8 \times 10^{5}$<br>4400 | $1.5 \times 10^{6}$<br>2410 | $1.1 \times 10^{6}$<br>1250 | $1.3 \times 10^{6}$<br>710 | $1.7 \times 10^{6}$<br>440 | $1.4 \times 10^{6}$<br>230 | $1.7 \times 10^{6}$<br>110 | $1.3 \times 10^{6}$<br>21 |
| 110 | 0<br>5710 | $1.1 \times 10^{3}$<br>4500 | $1.3 \times 10^{4}$<br>2200 | $1.3 \times 10^{6}$<br>1020 | $1.6 \times 10^{6}$<br>560 | $1.9 \times 10^{6}$<br>361 | $2.3 \times 10^{6}$<br>187 | $1.7 \times 10^{6}$<br>89 | $1.5 \times 10^{6}$<br>16 |

Target-to-Substrate Distance

It is clearly understood from Table 3 that the critical current densities were extremely reduced or zeroed when the target-to-substrate distances were below 40 mm as in the case of 30 mm, regardless of the film deposition rates.

When the target-to-substrate distances were in the range of 40 to 100 mm, on the other hand, it was possible to maintain high critical current densities at the film deposition rates exceeding 2000 Å/min.

When the target-to-substrate distances exceeded 100 mm, as in the case of 110 mm, the critical current densities were extremely reduced at the film deposition rates exceeding 2000 Å/min.

Experimental Example 4 (Substrate Temperature)

Except for the laser repetition rate and the substrate temperature, the film deposition conditions were set as follows:

Oxygen Gas Flow Rate during Film Deposition: 100 SCCM
Oxygen Gas Pressure during Film Deposition: 200 mTorr
Target-to-Substrate Distance: 70 mm
Laser Energy Density on Target Surface: 2.5 J/cm$^2$
Laser Pulse Energy : 400 mJ

The substrate temperature [°C] was varied as shown in Table 4, to form films under the respective repetition rates.

As to the numerical values listed with no item names in Table 4, the upper values show critical temperatures and the lower values show critical current densities [A/cm$^2$]. The film deposition rates represent average values of those for forming the films at various substrate temperatures, in units of [Å/min.].

Table 4

| Substrate Temperature \ Repetition Rate | 1 | 5 | 10 | 20 | 30 | 50 | 100 | 200 | 250 |
|---|---|---|---|---|---|---|---|---|---|
| 550 | 17K, 0 | < 4.2K, 0 | < 4.2K, 0 | < 4.2K, 0 | < 4.2K, 0 | < 4.2K, 0 | < 4.2K, 0 | < 4.2K, 0 | < 4.2K, 0 |
| 600 | 83K, $1.3 \times 10^6$ | 82K, $1.2 \times 10^6$ | 83K, $1.1 \times 10^6$ | 83K, $9.5 \times 10^5$ | 82K, $3.8 \times 10^5$ | 83K, $3.7 \times 10^5$ | 81K, $2.9 \times 10^5$ | 82K, $2.6 \times 10^5$ | 81K, $2.3 \times 10^5$ |
| 700 | 91K, $3.5 \times 10^6$ | 90K, $3.3 \times 10^6$ | 87K, $4.1 \times 10^6$ | 88K, $3.1 \times 10^6$ | 89K, $2.5 \times 10^6$ | 86K, $1.8 \times 10^6$ | 85K, $1.9 \times 10^6$ | 84K, $1.8 \times 10^6$ | 84K, $1.2 \times 10^6$ |
| 800 | 87K, $2.1 \times 10^6$ | 87K, $2.5 \times 10^6$ | 86K, $1.9 \times 10^6$ | 87K, $1.4 \times 10^6$ | 88K, $1.2 \times 10^6$ | 87K, $1.3 \times 10^6$ | 88K, $1.5 \times 10^6$ | 89K, $1.6 \times 10^6$ | 87K, $1.1 \times 10^6$ |
| 850 | 88K, $1.5 \times 10^6$ | 88K, $1.3 \times 10^6$ | 86K, $1.7 \times 10^6$ | 84K, $8.2 \times 10^5$ | 84K, $3.8 \times 10^5$ | 35K, 0 | 10K, 0 | 4.2K, 0 | 4.2K, 0 |
| Film Deposition Rate | 65 | 315 | 628 | 1250 | 1890 | 3350 | 6790 | 13700 | 17500 |

It is clearly understood from Table 4 that superconducting properties such as the critical temperatures and the critical current densities were deteriorated when the substrate temperatures were below 600°C, as in the case of 550°C, regardless of the film deposition rates.

At the substrate temperatures of 600 to 800°C, on the other hand, high properties were maintained under the film deposition rates exceeding 2000 Å/min.

When the substrate temperatures exceeded 800°C as in the case of 850°C, the properties were significantly reduced at the film deposition rates exceeding 2000 Å/min.

Experimental Example 5 (Laser Energy Density)

Except for the laser repetition rate and the laser energy density on the target surface, the film deposition conditions were set as follows:

Oxygen Gas Flow Rate during Film Deposition: 100 SCCM
Oxygen Gas Pressure during Film Deposition: 200 mTorr
Target-to-Substrate Distance: 70 mm
Substrate Temperature: 650°C
Laser Pulse Energy: 400 mJ

The laser energy density [J/cm²] on the target surface was varied as shown in Table 5, to form films under the respective repetition rates.

As to the numerical values listed with no item names in Table 5, upper values show critical temperatures, and the lower values show critical current densities [A/cm²]. The parenthesized numerical values show film deposition rates [Å/min.].

Table 5

| Energy Density (J/cm²) | Repetition Rate |  |  |  |  |  |  |  |  |
|---|---|---|---|---|---|---|---|---|---|
|  | 1 | 5 | 10 | 20 | 30 | 50 | 100 | 200 | 250 |
| 0.2 | < 4.2K<br>0<br>(41) | < 4.2K<br>0<br>(215) | < 4.2K<br>0<br>(530) | < 4.2K<br>0<br>(920) | < 4.2K<br>0<br>(1750) | < 4.2K<br>0<br>(2810) | < 4.2K<br>0<br>(5680) | < 4.2K<br>0<br>(12400) | < 4.2K<br>0<br>(15200) |
| 0.5 | < 4.2K<br>0 | < 4.2K<br>0 | < 4.2K<br>0 | < 4.2K<br>0 | < 4.2K<br>0 | < 4.2K<br>0 | < 4.2K<br>0 | < 4.2K<br>0 | < 4.2K<br>0 |
| 0.8 | 67K<br>0 | 52K<br>0 | 30K<br>0 | < 4.2K<br>0 | < 4.2K<br>0 | < 4.2K<br>0 | < 4.2K<br>0 | < 4.2K<br>0 | < 4.2K<br>0 |
| 1 | 83K<br>$1.8 \times 10^6$<br>(53) | 85K<br>$1.5 \times 10^6$<br>(295) | 82K<br>$1.9 \times 10^6$<br>(590) | 83K<br>$1.7 \times 10^6$<br>(1150) | 82K<br>$1.8 \times 10^6$<br>(1910) | 83K<br>$1.2 \times 10^6$<br>(3050) | 82K<br>$1.0 \times 10^6$<br>(6020) | 81K<br>$3.2 \times 10^5$<br>(12300) | 81K<br>$1.7 \times 10^5$<br>(15600) |
| 2 | 91K<br>$1.5 \times 10^6$<br>(60) | 90K<br>$1.3 \times 10^6$<br>(315) | 89K<br>$2.0 \times 10^6$<br>(628) | 90K<br>$1.7 \times 10^6$<br>(1210) | 90K<br>$1.4 \times 10^6$<br>(1830) | 88K<br>$1.1 \times 10^6$<br>(3210) | 87K<br>$1.1 \times 10^6$<br>(6310) | 86K<br>$9.3 \times 10^5$<br>(12900) | 87K<br>$8.4 \times 10^5$<br>(16100) |
| 3 | 90K<br>$1.3 \times 10^6$<br>(60) | 90K<br>$1.2 \times 10^6$<br>(320) | 88K<br>$2.0 \times 10^6$<br>(650) | 89K<br>$1.7 \times 10^6$<br>(1350) | 87K<br>$1.5 \times 10^6$<br>(2050) | 87K<br>$1.1 \times 10^6$<br>(3300) | 87K<br>$9.2 \times 10^5$<br>(6400) | 88K<br>$5.3 \times 10^5$<br>(13100) | 88K<br>$4.2 \times 10^5$<br>(16500) |

It is clearly understood from Table 5 that the superconducting properties were extremely deteriorated when the energy densities were less than 1 J/cm², as in the cases of 0.2 J/cm², 0.5 J/cm² and 0.8 J/cm².

When the energy densities were in excess of 1 J/cm$^2$, on the other hand, oxide superconducting films of high performance were obtained regardless of the film deposition rates.

Experimental Example 6 (Laser Pulse Energy)

Except for the laser repetition rate and the laser pulse energy, the film deposition conditions were set as follows:

Oxygen Gas Flow Rate during Film Deposition: 100 SCCM
Oxygen Gas Pressure during Film Deposition: 200 mTorr
Target-to-Substrate Distance: 60 mm
Substrate Temperature: 750°C
Laser Energy Density on Target Surface: 3 J/cm$^2$

The laser pulse energy [mJ] was varied as shown in Table 6, to form films under the respective repetition rates.

Referring to Table 6, the numerical values listed with no item names show critical temperatures, and the parenthesized numerical values show film deposition rates [Å/min.].

Table 6

| Repetition Rate | Laser Energy |||||||||
|---|---|---|---|---|---|---|---|---|---|
| | 1 | 5 | 10 | 20 | 30 | 50 | 100 | 200 | 250 |
| 8 | < 4.2K | < 4.2K | < 4.2K | < 4.2K | < 4.2K | < 4.2K | < 4.2K | < 4.2K | < 4.2K |
| 10 | 82K (28) | 83K (125) | 82K (270) | 81K (510) | 80K (690) | 81K (1300) | 79K (2600) | 78K (5200) | 78K (6600) |
| 15 | 83K (28) | 83K (139) | 81K (290) | 84K (580) | 79K (820) | 80K (1400) | 80K (2900) | 79K (6100) | 78K (7300) |
| 20 | 89K (35) | 88K (160) | 86K (320) | 89K (610) | 87K (910) | 88K (1600) | 85K (3300) | 84K (6800) | 83K (8100) |

It is clearly understood from Table 6 that oxide superconducting films having high critical temperatures were obtained at the laser energy values exceeding 10 mJ, regardless of the film deposition rates.

# EP 0 451 782 B1

## Claims

1. A method of preparing a high temperature oxide super-conducting film having a critical current density of at least $1 \times 10^5$ A/cm² on a substrate using laser ablation, comprising the steps of applying a laser beam to a target containing components of an oxide superconductor material and depositing particles, being scattered from said target, on the substrate, wherein said conditions of said film deposition satisfy the following conditions

   a. an oxygen gas flow rate during film deposition of 50 to 70 SCCM;

   b. am oxygen gas pressure during film deposition of 0.13332 to 133.32 Pa (10 to 1000 mTorr);

   c. a target-to-substrate distance of 40 to 60 mm;

   d. a substate temperature of 600 to 800 °C;

   e. a laser energy density on the target surface of 1 to 3 J/cm2; and

   f. a laser pulse energy of at least 10 mJ,

   characterized in that the film deposition rate is not lower than 12300 Å/min, and that a MgO substrate is used.

2. A method of preparing an oxide superconducting film in accordance with claim 1, wherein said oxide super-conductive material has a composition of Y-Ba-Cu-O.

## Patentansprüche

1. Verfahren zur Herstellung eines Hochtemperatur Oxid supraleitenden Filmes mit einer kritischen Stromdichte von mindestens $1 \times 10^5$ A/cm² auf einem Substrat unter Verwendung von Laserablation, welches die Schritte des Anwendens eines Laserstrahls auf ein Target, welches Bestandteile eines Oxid-Supraleitermaterials enthält, und Abscheiden von Teilchen, welche von dem Target gestreut werden, auf das Substrat umfaßt, worin die Bedingungen der Filmabscheidung die folgenden Bedingungen erfüllen:

   a. einen Sauerstoffgasdurchsatz während der Filmabscheidung von 50 bis 70 SCCM;

   b. einen Sauerstoffgasdruck während der Filmabscheidung von 0,13332 bis 133,32 Pa (10 bis 1000 mTorr);

   c. einen Abstand vom Target zum Substrat von 40 bis 60 mm;

   d. eine Substrattemperatur von 600 bis 800°C;

   e. eine Laserenergiedichte auf der Targetoberfläche von 1 bis 3 J/cm²; und

   f. eine Laserpulsenergie von mindestens 10 mJ,

   dadurch gekennzeichnet, daß die Filmabscheidungsrate nicht geringer als 12300 Å/min ist und daß ein MgO-Substrat verwendet wird.

2. Verfahren zur Herstellung eines Oxid-supraleitenden Filmes gemäß Anspruch 1, worin das Oxid-supraleitende Material eine Zusammensetzung von Y-Ba-Cu-O besitzt.

## Revendications

1. Procédé de préparation d'un film en oxyde supraconducteur à haute température présentant une densité de courant d'au moins $1 \times 10^5$ A/cm² sur un substrat par ablation au laser, comprenant les étapes d'application d'un faisceau laser sur une cible contenant les composants d'un matériau en oxyde supraconducteur et le dépôt de particules, une fois dispersées à partir de ladite cible, sur le substrat, procédé dans lequel ledit mode dudit dépôt de film répond aux conditions suivantes:

   a. un débit d'oxygène gazeux pendant le dépôt du film de 50 à 70 SCCM;

   b. une pression d'oxygène gazeux pendant le dépôt du film de 0,13332 à 133,32 Pa (10 à 1000 mTorr);

   c. une distance entre la cible et le substrat de 40 à 60 mm;

   d. une température de substrat de 600 à 800°C;

   e. une densité d'énergie laser à la surface de la cible de 1 à 3 J/cm²; et

   f. une énergie de pulsation du laser d'au moins 10 mJ, procédé caractérisé en ce que la vitesse de dépôt du film n'est pas inférieure à 12300 Å/min., et en ce qu'un substrat en MgO est utilisé.

2. Procédé de préparation d'un film en oxyde supraconducteur selon la revendication 1, dans lequel la composition dudit matériau en oxyde supraconducteur est à base de Y-Ba-Cu-O.

16

# *FIG.1*